# FASCICULE DE BREVET EUROPEEN

(11) **EP 3 369 147 B1**
(45) Date de publication et mention de la délivrance du brevet: **25.12.2019**
(21) Numéro de dépôt: 16785532.9
(22) Date de dépôt: 26.10.2016
(51) Int. Cl.: H01S 5/022, H01S 5/22, H01S 5/34, H01S 5/042

(54) **ENSEMBLE COMPORTANT UN LASER À CASCADE QUANTIQUE, ET UNE EMBASE ASSOCIÉE**
ANORDNUNG MIT EINEM QUANTENKASKADENLASER UND ZUGEHÖRIGE BASIS
ASSEMBLY COMPRISING A QUANTUM CASCADE LASER, AND AN ASSOCIATED BASE

(30) Priorité: 30.10.2015 FR 1560445
(43) Date de publication de la demande: 05.09.2018
(73) Titulaire: Université Paris Diderot (Paris 7), 75013 Paris (FR); Centre National de la Recherche Scientifique (CNRS), 75016 Paris (FR)
(72) Inventeur: GELLIE, Pierre, 75015 Paris (FR)
(74) Mandataire: Regimbeau
(86) Numéro de dépôt international: PCT/EP2016/075804
(87) Numéro de publication internationale: WO 2017/072175

(56) Documents cités:
- US-A- 5 357 536
- US-A1- 2013 243 020
- US-B1- 7 826 511
- OLAF KRUGER ET AL: "Epitaxial-Side Mounting of Terahertz Quantum- Cascade Lasers for Improved Heat Management", IEEE PHOTONICS TECHNOLOGY LETTERS, IEEE SERVICE CENTER, PISCATAWAY, NJ, US, vol. 25, no. 16, 1 août 2013 (2013-08-01), pages 1570-1573, XP011521997, ISSN: 1041-1135, DOI: 10.1109/LPT.2013.2271323 cité dans la demande

## Description

### DOMAINE DE L'INVENTION

La présente invention concerne le domaine des lasers à cascade quantique. L'invention concerne plus précisément un ensemble comportant une source laser à cascade quantique et une embase destinée à assurer l'alimentation et la thermalisation du laser.

### ETAT DE LA TECHNIQUE

Une source laser, par la suite simplement appelée laser, est une source capable de générer un rayonnement spatialement et temporellement cohérent basé sur l'effet laser (acronyme de l'anglais « Light Amplification by Stimulated Emission of Radiation », en français : « amplification de la lumière par émission stimulée de rayonnement).

Un laser à cascade quantique (aussi appelé QCL, quantum cascade laser en anglais) est un laser dans lequel l'inversion de population est atteinte grâce à la relaxation des électrons entre deux niveaux situés dans la bande de conduction d'une hétérostructure semi-conductrice. Ces transitions intersous-bandes sont obtenues par le confinement des électrons dans une série de puits quantiques disposés en cascade et réalisés par épitaxie sur un substrat.

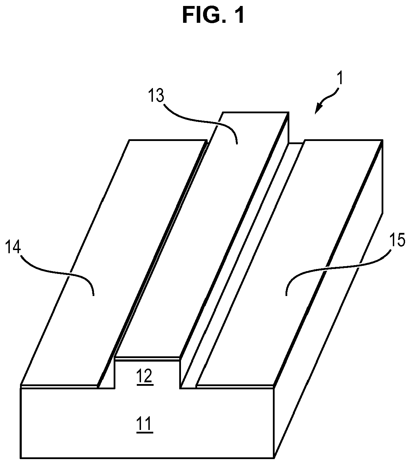

Comme illustré sur la figure 1, un laser à cascade quantique 1 comprend classiquement :
- un substrat isolant 11,
- un guide d'onde nervuré 12 formé par gravure de couches épitaxiée sur le substrat isolant 11, ledit guide d'onde semi-conducteur 12 formant une zone de gain,
- un contact électrique supérieur 13 disposé sur le guide d'onde semi-conducteur
   12,
- deux contacts électriques latéraux 14, 15 disposés sur le substrat isolant 11 à distance du contact électrique supérieur 13.

Un laser 1 est classiquement monté sur une embase 2 qui assure son alimentation.

Des micro-fils électriques, par exemple en or, relient électriquement les pistes 14, 15 et 13 à des contacts électriques déportés sur des embases en céramiques pouvant accueillir des sondes électriques pour l'alimentation du laser.

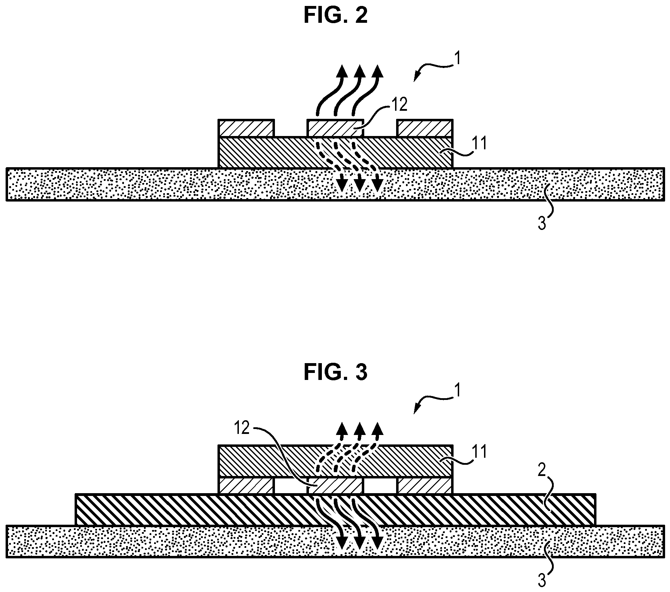

Comme illustré sur la figure 2, il est connu de monter un laser 1 face épitaxiée vers le haut, le substrat isolant 11 du laser étant en contact avec un réservoir thermique 3 froid, typiquement un cryostat.

Lorsque le laser 1 est monté face épitaxiée vers le haut (c'est-à-dire que la face du substrat isolant 11 en contact avec le réservoir thermique 3 est la face opposée à la face du substrat isolant 11 sur laquelle est formé le guide d'onde 12), le guide d'onde semi-conducteur 12 est entouré de vide, la dissipation thermique de la chaleur générée dans le guide d'onde semi-conducteur 12 se fait principalement par le substrat isolant 11. Lorsque le substrat isolant 11 a une conductivité thermique faible, comme par exemple dans le cas d'un substrat isolant en Ga/As, il y a une mauvaise diffusion de la chaleur générée dans le guide d'onde semi-conducteur 12, ce qui impacte de manière négative les performances du laser 1.

Pour améliorer la dissipation thermique de la chaleur générée dans le guide d'onde semi-conducteur 12, il a été proposé de monter le laser 1 sur une embase 2 thermiquement conductrice, le laser 1 étant face épitaxiée vers le bas, ce qui signifie que le guide d'onde semi-conducteur 12 est en contact avec l'embase 2 elle-même en contact avec un réservoir thermique 3 froid, comme illustré sur la figure 3.

Lorsque le substrat 11 est dopé et donc électriquement conducteur, le laser peut être alimenté à travers le substrat 11. Ainsi, il n'y a pas besoin d'utiliser des fils d'or au niveau de ces contacts longilignes.

Toutefois, ceci n'est pas possible avec un laser ayant un substrat 11 non dopé et donc électriquement isolant, comme par exemple les lasers semi-conducteur à cascade quantique et notamment des lasers teraherz.

Le document "Epitaxial-side Mounting of Terahertz Quantum-Cascade Lasers for Improved Heat Management", par exemple, décrit un montage face épitaxiée vers le bas dans lequel la connexion électrique entre le contact électrique latéral 19 du laser 1 et un contact électrique latéral 27 de l'embase 2 est assurée par un report de contact 28, réalisé par isolation partielle à l'aide d'un dépôt nanométrique d'un matériau isolant par dépôt en phase vapeur puis d'une évaporation d'une couche métallique, nécessitant donc deux étapes de lithographies supplémentaires. Des micro-fils électriques, par exemple en or, relient le contact latéral 27 à des contacts électriques déportés sur des embases en céramiques pouvant accueillir des sondes électriques.

Cependant, ces fils d'or sont peu robustes et risquent de se décoller au fur et à mesure des cycles de refroidissement ou de fondre si le courant est trop élevé. En outre, la fabrication et le montage du laser sur l'embase sont plus complexes à mettre en œuvre.

### EXPOSE DE L'INVENTION

Un but de l'invention est de proposer un ensemble comportant un laser à cascade quantique et une embase associée, permettant un montage du laser sur l'embase plus simple et plus facile à mettre en œuvre, et en particulier ne nécessitant pas de fils d'or.

Ce but est atteint dans le cadre de la présente invention grâce à un ensemble comportant un laser à cascade quantique, et une embase associée, le laser à cascade quantique comprenant :
- un substrat isolant,
- au moins un guide d'onde semi-conducteur formé par gravure de couches épitaxiée sur le substrat isolant, en saillie du substrat isolant, et possédant une structure à cascade quantique, ledit guide d'onde semi-conducteur formant une zone de gain,
- un contact électrique supérieur disposé selon une longueur du guide d'onde semi-conducteur,
- au moins un contact électrique latéral disposé selon une longueur du substrat isolant à distance du contact électrique supérieur,
l'embase comprenant :
- une matrice thermiquement conductrice et électriquement isolante,
- un contact électrique central disposé selon une longueur de la matrice,
- au moins un contact électrique latéral disposé à distance du contact électrique central disposé selon une longueur de la matrice,
l'ensemble étant caractérisé en ce que la matrice thermiquement conductrice et isolante électriquement est structurée de manière à épouser la forme du guide d'onde du laser et la forme du substrat isolant pour que :
- le contact électrique supérieur du laser soit en contact avec le contact électrique central de l'embase sur la longueur de la matrice,
- le contact électrique latéral du laser soit en contact avec le contact électrique latéral de l'embase.

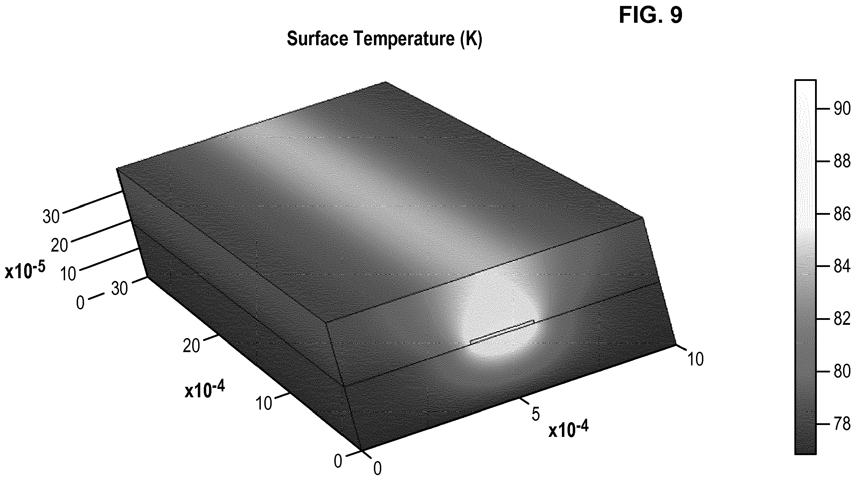

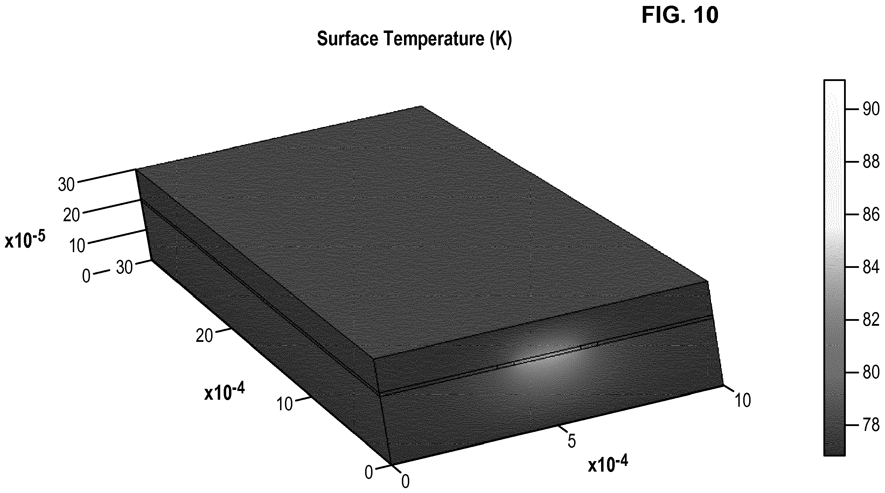

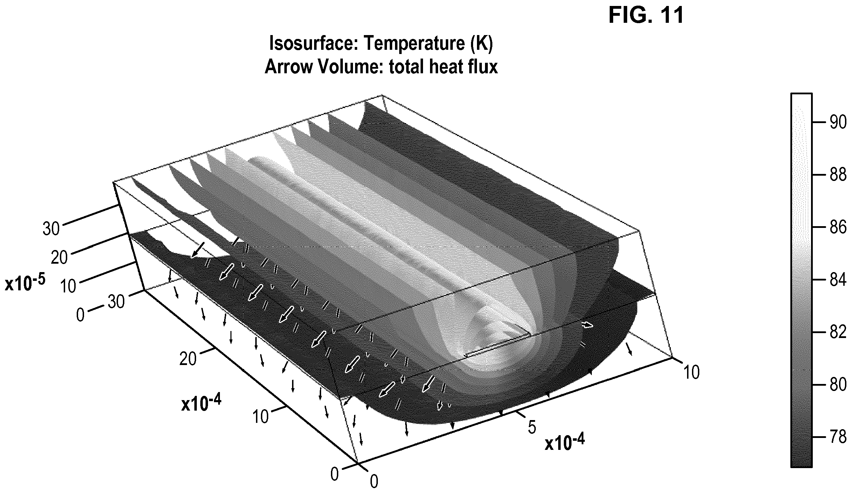

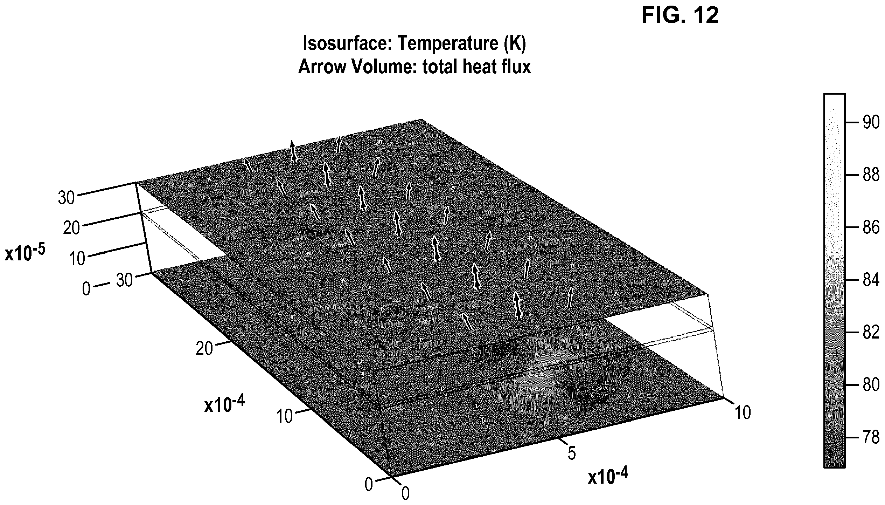

La matrice est structurée de manière à épouser la forme du guide d'onde du laser, de manière à pouvoir déporter les contacts électriques du laser ce qui permet d'alimenter facilement le laser tout en assurant une dissipation efficace de la chaleur émise par la région active du laser dans le guide d'onde du laser vers le réservoir thermique froid. De cette manière la température interne du laser est abaissée de plusieurs dizaines de Kelvins et les performances en termes de puissance optique du laser sont augmentées de manière significative. Ces résultats sont confirmés par une simulation thermique de l'ensemble à l'aide d'un programme de simulation par éléments finis dans lequel la puissance injectée dans la région active du laser est de 10W et le thermostat est à 77K (voir les figures 9 à 12).

L'invention est avantageusement complétée par les caractéristiques suivantes, prises individuellement ou en l'une quelconque de leurs combinaisons techniquement possibles.

Un logement est ménagé dans la matrice, le laser comprenant des contacts électriques latéraux disposés sur le substrat isolant de part et d'autre du guide d'onde semi-conducteur, l'embase comprenant des contacts électriques latéraux disposés de part et d'autre du contact électrique central de l'embase, le logement étant adapté pour recevoir le guide d'onde semi-conducteur du laser, de manière à ce que le contact électrique supérieur du laser soit en contact avec le contact électrique central de l'embase, et à ce que les contacts électriques latéraux du laser soient en contact avec les contacts électriques latéraux de l'embase.

Le logement présente une partie avant et une partie arrière, le contact électrique central et les contacts électriques latéraux de l'embase se prolongent vers la partie arrière qui se trouve à l'arrière et à distance du laser, le laser se situant lui dans la partie avant de la matrice, la partie arrière étant destinée à recevoir des sondes électriques pour l'alimentation électrique du laser.

Les contacts électriques latéraux sont déportés vers la partie arrière et le contact électrique central présente vers la partie arrière une largeur augmentée dans le logement.

Les contacts électriques latéraux de l'embase ne comportent pas de fil électrique dans la partie avant de la matrice.

Le laser est en forme de T renversé, présentant une branche horizontale et une branche verticale, la branche verticale du T correspondant au guide d'onde et comportant le contact électrique supérieur, la branche horizontale comportant les contacts électriques latéraux, et le logement présente une forme de glissière dans la matrice comportant le contact électrique central à une extrémité inférieure de la glissière et à une extrémité supérieure des rebords longilignes au logement et comportant les contacts électriques latéraux de l'embase

La matrice est dans un matériau ayant une conductivité thermique supérieure à 500 W·m⁻¹·K⁻¹ pour des températures comprises entre 20 et 200 K.

La matrice est dans un matériau ayant un coefficient de dilatation thermique égale à + ou - 20% à celui du matériau du guide d'onde semi-conducteur.

La matrice est dans un matériau ayant une conductivité électrique inférieure à 10⁶ S·m⁻¹.

Le contact électrique supérieur du laser est soudé au contact électrique central de l'embase, les contacts électriques latéraux du laser étant soudés aux contacts électriques latéraux de l'embase.

### DESCRIPTION DES FIGURES

D'autres objectifs, caractéristiques et avantages sortiront de la description détaillée qui suit en référence aux dessins donnés à titre illustratif et non limitatif parmi lesquels :
- la figure 1 illustre un laser à cascade quantique selon l'art antérieur ;
- la figure 2 illustre un laser à cascade quantique monté face épitaxiée vers le haut selon l'art antérieur ;
- la figure 3 illustre un laser à cascade quantique monté face épitaxiée vers le bas selon l'art antérieur ;

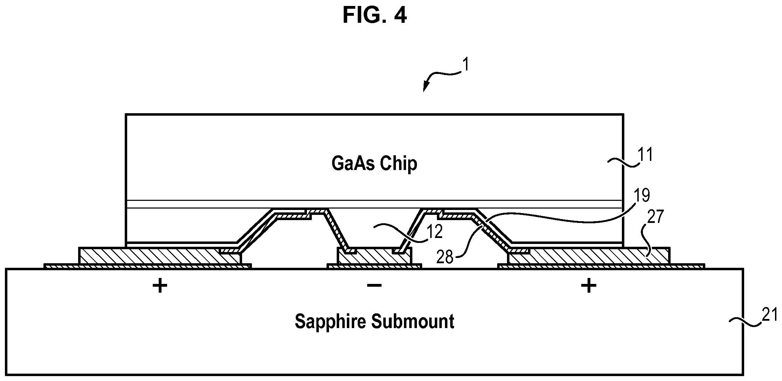

- la figure 4 illustre un exemple d'assemblage d'un laser à cascade quantique monté face épitaxiée vers le bas selon l'art antérieur ;
- la figure 5 illustre une embase conforme à un mode de réalisation de l'invention ;
- la figure 6 illustre un laser à cascade quantique à cascade quantique selon l'art antérieur ;
- les figures 7 et 8 illustrent un ensemble constitué d'un laser et d'une embase conforme à un mode de réalisation de l'invention ;
- les figures 9 et 10 représentent la distribution de température, respectivement dans un laser monté face épitaxiée vers le haut et dans un ensemble conforme à l'invention ;
- les figures 11 et 12 représentent les surfaces isothermes, respectivement dans un laser monté face épitaxiée vers le haut et dans un ensemble conforme à l'invention.

### DESCRIPTION DETAILLEE DE L'INVENTION

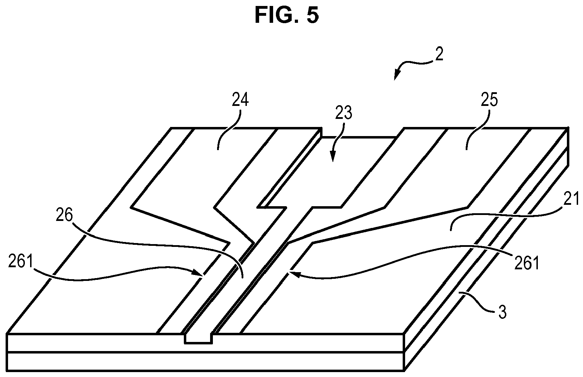

Un ensemble comportant un laser à cascade quantique 1 et une embase associée 2 est illustré par les figures 5 à 8.

L'invention s'applique en particulier aux lasers à cascade quantique émettant dans la gamme de fréquence du térahertz (entre 1 et 5 THz soit entre 60 et 300µm de longueur d'onde). Ces lasers délivrent des puissances moyennes supérieures à 100µW. Le fonctionnement d'un laser à cascade quantique peut être de type continu ou pulsé (créneaux de tension à une fréquence allant de 1kHz à 100kHz et de durée allant de 100ns à 1ms).

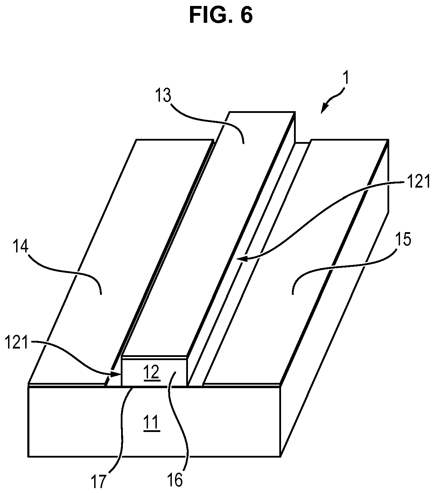

En référence à la figure 6, le laser à cascade quantique à cascade quantique 1 comprend :
- un substrat 11,
- un cristal semi-conducteur 16 dans lequel est formé un guide d'onde semi-conducteur 12.

Le cristal semi-conducteur 16 est formé par superposition de couches épitaxiées sur le substrat 11.

Le guide d'onde semi-conducteur 12 est formé par gravure du cristal semi-conducteur 16.

Le guide d'onde semi-conducteur 12 défini une zone de gain du laser aussi appelée région active du laser. Le guide d'onde semi-conducteur 12 assure le confinement optique horizontal de la zone de gain.

La distance séparant les parois latérales 121 du guide d'onde est au minimum de 50µm et 500µm au maximum.

Dans le cas d'un laser à cascade quantique, le guide d'onde semi-conducteur 12 possède une structure semi-conductrice hétérogène, dite « à cascade quantique ». Cette structure est bien connue et est classiquement composée d'une multitude de puits quantiques couplés. La structure est composée par exemple de GaAs/GaAlAs dont la croissance par épitaxie à jet moléculaire a été réalisée sur le substrat 11. La structure est composée par exemple de couches successives de GaAs et d'Al_{0.x} Ga₁₋ₓAs (x variant de 5% à 20%) dont la croissance par épitaxie à jet moléculaire a été réalisée sur le substrat 11 en GaAs.

Le champ électrique est à la fois dans les zones 16 et 11 (substrat en GaAs). Les QCL émettant, à la fois dans le térahertz et le moyen-infrarouge, sont des lasers qui utilisent couramment ce type de guide d'onde.

Le laser 1 comprend en outre trois contacts électriques permettant d'alimenter en courant la zone active du laser :
- un contact électrique supérieur 13 (ou piste électrique) disposé sur le guide d'onde semi-conducteur 12 selon la longueur du laser 1,
- deux contacts électriques latéraux 14, 15 (ou pistes électriques) disposés sur le substrat 11 de part et d'autre et à distance du contact électrique supérieur 13, selon la longueur du laser 1.

Par « à distance », on entend que les contacts électriques latéraux 14 ,15 ne sont pas en contact avec le contact électrique supérieur 13. La distance entre le contact électrique latéral 14 (respectivement 15) et le contact électrique supérieur 13, mesurée selon une direction perpendiculaire aux plans du contact 13 est typiquement comprise entre 5 microns et 100 microns.

Le laser 1 comprend deux contacts électriques latéraux 14, 15 disposés sur le substrat 11 de part et d'autre du guide d'onde semi-conducteur 12,

Le laser 1 présente une section transversale en forme de T renversé, comportant une branche verticale et une branche horizontale, la branche verticale du T correspondant à la section transversale du guide d'onde 12 et à la partie épitaxiée 16, et la branche horizontale correspondant à la section transversale du substrat 11.

La longueur du guide d'onde 12 est comprise entre 250µm et 10mm.

La dimension des contacts électriques latéraux 14, 15 dans la direction longitudinale du guide d'onde semi-conducteur 12 est identique à la longueur du guide d'onde semi-conducteur 12 dans cette direction.

L'invention est particulièrement avantageuse dans le cas d'un substrat 11 non dopé ou faiblement dopé, donc isolant électriquement, par exemple en Ga/As, mais elle peut aussi s'appliquer à un laser 1 ayant un substrat dopé conducteur pour améliorer la diffusion du montage face épitaxiée vers le bas.

Le laser 1 comporte en outre une couche conductrice 17, par exemple le même semi-conducteur mais fortement dopé qui conduit le courant électrique et qui laisse passer le champ électrique, située entre le substrat 11 et le cristal semi-conducteur 16, sur toute la largeur de l'embase 11, et donc ici sous les contacts électriques 14 et 15.

Le contact électrique supérieur 13 et la couche conductrice 17 assurent un confinement optique vertical de la zone de gain.

La distance séparant les deux couches 13 et 17 est au minimum de 150nm et 20µm au maximum.

Comme illustré sur la figure 5, l'embase 2 comprend :
- un réservoir thermique 3 froid,
- une matrice 21, en contact, de préférence direct, avec le réservoir thermique 3,
- un contact électrique central 23 (ou piste électrique) selon la longueur de la matrice 21,
- deux contacts électriques latéraux 24 et 25 (ou pistes électriques) disposés de part et d'autre et à distance du contact électrique central 23 selon la longueur de la matrice 21.

Le réservoir thermique 3 froid est typiquement un doigt froid d'un cryostat et permet de maintenir une température comprise entre 40 et 100K.

En pratique, la distance entre chaque contact électrique latéral 24, 25 et le contact électrique central 23, mesurée selon une direction perpendiculaire aux plans des contacts 23, doit être au minimum de l'épaisseur du guide d'onde 12 (typiquement 10 microns) car le guide d'onde 12 ayant été formé par gravure chimique, les parois latérales 121 du guide d'onde 12 forment généralement un angle compris entre 40° et 50° avec le plan du substrat 11.

Il est cependant également possible de former le guide d'onde 12 de manière à ce qu'il présente des parois latérales 121 verticales mais de tels guides d'onde sont beaucoup plus contraignants à fabriquer.

La matrice 21 est thermiquement conductrice et électriquement isolante, aux températures cryogéniques, à savoir entre 40-100K.

La matrice 21 est dans un matériau ayant une conductivité thermique supérieure à 500 W·m⁻¹·K⁻¹ et préférentiellement à 1000 W·m⁻¹·K⁻¹ et une conductivité électrique inférieure à 10⁶ S·m⁻¹ et préférentiellement à 5.10⁵ S·m⁻¹ pour des températures comprises entre 20 et 200 K .

La matrice 21 est dans un matériau ayant un coefficient de dilatation thermique égale à + ou - 20% à celui du matériau du guide d'onde semi-conducteur 12.

La matrice 21 peut notamment être en saphir. En effet, le saphir conduit mieux la chaleur aux températures cryogéniques que le cuivre et son coefficient de dilatation thermique est proche du GaAs, ce qui permet de limiter les contraintes mécaniques dans la structure du laser.

La matrice 21 peut également être en MgO qui permet d'être plus facilement travaillée tout en étant moins chère. En contrepartie, elle conduit un peu moins bien la chaleur que le saphir pour des températures comprises entre 40-100K.

La matrice 21 est structurée de manière à épouser la forme du guide d'onde 12 du laser et la forme du substrat 11 isolant électrique pour que, d'une part, le contact électrique supérieur 13 du laser 1 soit en contact avec le contact électrique central 23 de l'embase 2, et d'autre part, que les contacts électriques latéraux 14 et 15 du laser 1 soient respectivement en contact avec les contacts électriques latéraux 24 et 25 de l'embase 2.

Plus précisément, un logement 26, formé par un renfoncement, est ménagé dans la matrice 21 entre les deux contacts électriques latéraux 24, 25. Le contact électrique central 23 s'étend en partie dans la partie avant du logement 26 et en partie dans la partie arrière du logement 26.

Le logement 26 est adapté pour recevoir le guide d'onde semi-conducteur 12 du laser, de manière à ce que le contact électrique supérieur 13 du laser 1 soit en contact avec le contact électrique central 23 de l'embase 2, et à ce que les contacts électriques latéraux 14, 15 du laser 1 soient en contact respectivement avec les contacts électriques latéraux 24, 25 de l'embase 2.

La profondeur du renfoncement peut être égale à entre 95 et 105% de la hauteur du guide d'onde semi-conducteur 12 du laser.

Plus précisément encore, le logement 26 est réalisé de façon à présenter une forme de glissière dans la matrice 21, sensiblement rectangulaire pour recevoir la partie épitaxiée 16 du laser sensiblement rectangulaire.

Elle a par exemple une section perpendiculaire à son axe principal en forme de U pour recevoir la branche verticale du T correspondant.

La branche verticale du T comporte le contact électrique supérieur 13, la branche horizontale comportant les contacts électriques latéraux 14, 15. Le logement 26 présente une forme de glissière dans la matrice 21. Le contact électrique central 23 est disposé au fond de la glissière à une extrémité inférieure. Le logement 26 présente des rebords 261 plans à une extrémité supérieure, ces rebords plans 261 étant parallèle au et hors logement 26 dans cette partie avant et comportant les contacts électriques latéraux 24, 25 de l'embase en contact dans cette partie avant avec les contacts électriques latéraux 14, 15.Les contacts électriques latéraux 24, 25 de l'embase 2 se prolongent au-delà de la zone dans laquelle les contacts électriques latéraux 14, 15 du laser sont en contact avec les contacts électriques latéraux 24, 25 de l'embase 2.

Le contact électrique central 23 présente, au niveau de sa partie qui s'étend hors du logement 26, une surface augmentée, et en particulier une largeur augmentée, par rapport à la largeur du logement 26.

Ainsi, le logement 26 présente une partie avant de réception du laser 1 par laquelle sort la lumière du laser 1, et une partie arrière de réception des connecteurs électriques.

Les contacts électriques latéraux 24, 25 de l'embase 2 peuvent notamment se prolonger vers une partie arrière du logement 26 qui se trouve à l'arrière et à distance du laser, le laser 1 se situant lui dans une partie avant de la matrice conductrice thermique 21. Ces contacts 24,25 peuvent présenter des pistes élargies à l'arrière comme représenté sur les dessins.

On comprend ainsi que ce logement 26 facilite aussi le montage par l'insertion aisée de la partie épitaxiée dans la partie avant et des connecteurs dans la partie arrière.

Alternativement, les contacts électriques latéraux 24, 25 de l'embase 2 peuvent également se prolonger sur un côté de la matrice 21, dans une direction perpendiculaire à la longueur du guide d'onde 12.

Les contacts électriques latéraux 24, 26 de l'embase 2 étant déportés au-delà du logement 26, il est possible d'alimenter les contacts électriques latéraux 24, 25 de l'embase 2 avec des sondes électriques classiques et de s'affranchir de l'utilisation de fils en or.

Le contact électrique supérieur 13 du laser 1 peut être soudé au contact électrique central 23 de l'embase 2, et les contacts électriques latéraux 14, 25 du laser 1 peuvent être soudés respectivement aux contacts électriques latéraux 24, 25 de l'embase 2.

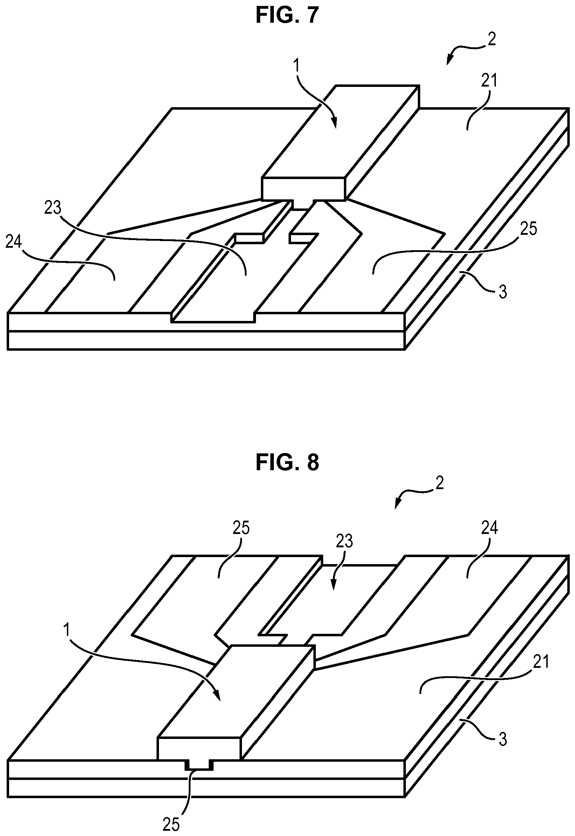

Comme représenté sur la figure 7 et 8, la partie supérieure du laser 1 est une couche métallisée, typiquement en or, permettant ainsi une soudure, par exemple à l'indium, de ce laser sur une embase refroidie (non représentée ici) facilitant la manipulation du laser et son maintien sur l'embase 21 par pression sur la face supérieure ainsi qu'une dissipation thermique supplémentaire (même si limitée) par le substrat 11.

Comme illustré par les figures 9 à 12, l'invention permet une diffusion thermique sensiblement plus efficace par l'utilisation de la matrice 21, que dans le cas d'un montage face épitaxiée vers le haut selon l'art antérieur. Dans cette simulation le réservoir thermique est fixé à 77K et la puissance dissipée dans la région active du laser et le guide d'onde est de 10W.

## Revendications

1. Ensemble comportant un laser à cascade quantique (1), et une embase (2) associée,
le laser à cascade quantique (1) comprenant :
- un substrat isolant (11),
- au moins un guide d'onde semi-conducteur (12) formé par gravure de couches épitaxiée sur le substrat isolant (11), en saillie du substrat isolant (11), et possédant une structure à cascade quantique, ledit guide d'onde semi-conducteur (12) formant une zone de gain,
- un contact électrique supérieur (13) disposé selon une longueur du guide d'onde semi-conducteur(12),
- au moins un contact électrique latéral (14, 15) disposé selon une longueur du substrat isolant (11) à distance du contact électrique supérieur (13),
l'embase (2) comprenant :
- une matrice (21) thermiquement conductrice et électriquement isolante,
- un contact électrique central (23) disposé selon une longueur de la matrice (21),
- au moins un contact électrique latéral (24, 25) disposé à distance du contact électrique central (23) disposé selon une longueur de la matrice (21),
l'ensemble étant **caractérisé en ce que** la matrice (21) thermiquement conductrice et isolante électriquement est structurée de manière à épouser la forme du guide d'onde du laser et la forme du substrat isolant (11) pour que :
- le contact électrique supérieur (13) du laser soit en contact avec le contact électrique central (23) de l'embase sur la longueur de la matrice,
- le contact électrique latéral (14, 15) du laser soit en contact avec le contact électrique latéral (24, 25) de l'embase.

2. Ensemble suivant la revendication 1, dans lequel un logement (26) est ménagé dans la matrice (21), le laser (1) comprenant des contacts électriques latéraux (14, 15) disposés sur le substrat isolant (11) de part et d'autre du guide d'onde semi-conducteur (12), l'embase (2) comprenant des contacts électriques latéraux (24, 25) disposés de part et d'autre du contact électrique central (23) de l'embase, le logement (26) étant adapté pour recevoir le guide d'onde semi-conducteur (12) du laser, de manière à ce que le contact électrique supérieur (13) du laser soit en contact avec le contact électrique central (23) de l'embase, et à ce que les contacts électriques latéraux (14, 15) du laser (1) soient en contact avec les contacts électriques latéraux (24, 25) de l'embase (2).

3. Ensemble suivant la revendication 2, dans lequel le logement (26) présente une partie avant et une partie arrière, le contact électrique central (23) et les contacts électriques latéraux (24, 25) de l'embase (2) se prolongent vers la partie arrière qui se trouve à l'arrière et à distance du laser (1), le laser se situant lui dans la partie avant de la matrice (21), la partie arrière étant destinée à recevoir des sondes électriques pour l'alimentation électrique du laser.

4. Ensemble suivant la revendication 3, les contacts électriques latéraux sont déportés vers la partie arrière et le contact électrique central (23) présente vers la partie arrière une largeur augmentée dans le logement (26).

5. Ensemble suivant l'une des revendications précédentes 2 à 4, dans lequel les contacts électriques latéraux (24, 25) de l'embase (2) ne comportent pas de fil électrique dans la partie avant de la matrice (21).

6. Ensemble suivant l'une des revendications précédentes 2 à 5, dans lequel le laser (1) est en forme de T renversé, présentant une branche horizontale et une branche verticale, la branche verticale du T correspondant au guide d'onde (12) et comportant le contact électrique supérieur (13), la branche horizontale comportant les contacts électriques latéraux (14, 15), et le logement (26) présente une forme de glissière dans la matrice (21) comportant le contact électrique central à une extrémité inférieure de la glissière et à une extrémité supérieure des rebords longilignes au logement (26) et comportant les contacts électriques latéraux (24, 25) de l'embase.

7. Ensemble suivant l'une des revendications précédentes, la matrice (21) est dans un matériau ayant une conductivité thermique supérieure à 500 W·m⁻¹·K⁻¹ pour des températures comprises entre 20 et 200 K.

8. Ensemble suivant l'une des revendications précédentes, la matrice (21) est dans un matériau ayant un coefficient de dilatation thermique égale à + ou - 20% à celui du matériau du guide d'onde semi-conducteur (12).

9. Ensemble suivant l'une des revendications précédentes, la matrice (21) étant dans un matériau ayant une conductivité électrique inférieure à 10⁶ S·m⁻¹.

10. Ensemble suivant l'une des revendications précédentes, le contact électrique supérieur (13) du laser étant soudé au contact électrique central (23) de l'embase, les contacts électriques latéraux (14) du laser étant soudés aux contacts électriques latéraux (24) de l'embase (2).

## Patentansprüche

1. Anordnung, die einen Quantenkaskadenlaser (1) und eine zugehörige Basis (2) umfasst,
wobei der Quantenkaskadenlaser (1) umfasst:
- ein isolierendes Substrat (11),
- mindestens einen Halbleiterwellenleiter (12), der durch epitaktisches Ätzen von Schichten auf dem isolierenden Substrat (11) gebildet wird, vom isolierenden Substrat (11) vorspringt und eine Quantenkaskadenstruktur besitzt, wobei der Halbleiterwellenleiter (12) eine Verstärkungszone bildet,
- einen oberen elektrischen Kontakt (13), der entlang einer Länge des Halbleiterwellenleiters (12) angeordnet ist,
- mindestens einen seitlichen elektrischen Kontakt (14, 15), der entlang einer Länge des isolierenden Substrats (11) in Abstand zum oberen elektrischen Kontakt (13) angeordnet ist,
wobei die Basis (2) umfasst:
- eine wärmeleitende und elektrisch isolierende Matrix (21),
- einen mittleren elektrischen Kontakt (23), der entlang einer Länge der Matrix (21) angeordnet ist,
- mindestens einen in Abstand zum mittleren elektrischen Kontakt (23) angeordneten seitlichen elektrischen Kontakt (24, 25), der entlang einer Länge der Matrix (21) angeordnet ist,
wobei die Anordnung **dadurch gekennzeichnet ist, dass** die wärmeleitende und elektrisch isolierende Matrix (21) so strukturiert ist, dass sie sich der Form des Wellenleiters des Lasers und der Form des isolierenden Substrats (11) anfügt, damit:
- sich der obere elektrische Kontakt (13) des Lasers mit dem mittleren elektrischen Kontakt (23) der Basis auf der Länge der Matrix in Kontakt befindet,
- sich der seitliche elektrische Kontakt (14, 15) des Lasers mit dem seitlichen elektrischen Kontakt (24, 25) der Basis in Kontakt befindet.

2. Anordnung nach Anspruch 1, wobei eine Aufnahme (26) in der Matrix (21) ausgestaltet ist, wobei der Laser (1) seitliche elektrische Kontakte (14, 15) umfasst, die auf dem isolierenden Substrat (11) beidseits des Halbleiterwellenleiters (12) angeordnet sind, wobei die Basis (2) seitliche elektrische Kontakte (24, 25) umfasst, die beidseits des mittleren elektrischen Kontakts (23) der Basis angeordnet sind, wobei die Aufnahme (26) dafür geeignet ist, den Halbleiterwellenleiter (12) des Lasers so aufzunehmen, dass sich der obere elektrische Kontakt (13) des Lasers mit dem mittleren elektrischen Kontakt (23) der Basis in Kontakt befindet, und so, dass sich die seitlichen elektrischen Kontakte (14, 15) des Lasers (1) mit den seitlichen elektrischen Kontakten (24, 25) der Basis (2) in Kontakt befinden.

3. Anordnung nach Anspruch 2, wobei die Aufnahme (26) einen vorderen Teil und einen hinteren Teil aufweist, sich der mittlere elektrische Kontakt (23) und die seitlichen elektrischen Kontakte (24, 25) der Basis (2) zum hinteren Teil hin, der sich an der Hinterseite und in Abstand zum Laser (1) befindet, verlängern, wobei der Laser seinerseits im vorderen Teil der Matrix (21) liegt, wobei der hintere Teil dazu bestimmt ist, elektrische Sonden für die elektrische Versorgung des Lasers aufzunehmen.

4. Anordnung nach Anspruch 3, die seitlichen elektrischen Kontakte zum hinteren Teil hin versetzt sind und der mittlere elektrische Kontakt (23) zum hinteren Teil hin eine vergrößerte Breite in der Aufnahme (26) aufweist.

5. Anordnung nach einem der vorstehenden Ansprüche 2 bis 4, wobei die seitlichen elektrischen Kontakte (24, 25) der Basis (2) keinen elektrischen Draht im vorderen Teil der Matrix (21) umfassen.

6. Anordnung nach einem der vorstehenden Ansprüche 2 bis 5, wobei der Laser (1) in Form eines umgekehrten T ist, das einen horizontalen Schenkel und einen vertikalen Schenkel aufweist, wobei der vertikale Schenkel des T dem Wellenleiter (12) entspricht und den oberen elektrischen Kontakt (13) umfasst, wobei der horizontale Schenkel die seitlichen elektrischen Kontakte (14, 15) umfasst, und die Aufnahme (26) eine Schienenform in der Matrix (21) aufweist, die den mittleren elektrischen Kontakt an einem unteren Ende der Schiene und an einem oberen Ende Kanten umfasst, die sich an der Aufnahme (26) langstrecken und die seitlichen elektrischen Kontakte (24, 25) der Basis umfassen.

7. Anordnung nach einem der vorstehenden Ansprüche, die Matrix (21) aus einem Material ist, das bei Temperaturen im Bereich zwischen 20 und 200 K eine Wärmeleitfähigkeit von mehr als 500 W·m⁻¹·K⁻¹ aufweist.

8. Anordnung nach einem der vorstehenden Ansprüche, die Matrix (21) aus einem Material ist, das einen Wärmeausdehnungskoeffizienten von gleich + oder - 20 % desjenigen des Materials des Halbleiterwellenleiters (12) aufweist.

9. Anordnung nach einem der vorstehenden Ansprüche, wobei die Matrix (21) aus einem Material ist, das eine elektrische Leitfähigkeit von weniger als 10⁶ S·m⁻¹ aufweist.

10. Anordnung nach einem der vorstehenden Ansprüche, wobei der obere elektrische Kontakt (13) des Lasers an den mittleren elektrischen Kontakt (23) der Basis geschweißt ist, wobei die seitlichen elektrischen Kontakte (14) des Lasers an die seitlichen elektrischen Kontakte (24) der Basis (2) geschweißt sind.

## Claims

1. Assembly comprising a quantum cascade laser (1), and an associated base (2),
the quantum cascade laser (1) comprising:
- an insulating substrate (11),
- at least one semiconductor waveguide (12) formed by etching of layers epitaxied onto the insulating substrate (11), protruding from the insulating substrate (11), and having a quantum cascade structure, said semiconductor waveguide (12) forming a gain zone,
- an upper electric contact (13) disposed according to a length of the semiconductor (12) wave guide,
- at least one lateral electric contact (14, 15) disposed according to a length of the insulating substrate (11) at a distance from the upper electric contact (13),
- the base (2) comprising:
- a thermally conductive and electrically insulating matrix (21),
- a central electric contact (23) disposed according to a length of the matrix (21),
- at least one lateral electric contact (24, 25) disposed at a distance from the central electric contact (23) disposed according to a length of the matrix (21),
the assembly being **characterised in that** the thermally conductive and electrically insulating matrix (21) is structured in such a way as to conform to the shape of the waveguide of the laser and the shape of the insulating substrate (11) in order for:
- the upper electric contact (13) of the laser to be in contact with the central electric contact (23) of the base over the length of the matrix,
- the lateral electric contact (14, 15) of the laser to be in contact with the lateral electric contact (24, 25) of the base.

2. Assembly according to claim 1, wherein a housing (26) is made in the matrix (21), the laser (1) comprising lateral electric contacts (14, 15) disposed on the insulating substrate (11) on either side of the semiconductor waveguide (12), the base (2) comprising lateral electric contacts (24, 25) disposed on either side of the central electric contact (23) of the base, the housing (26) being adapted for receiving the semiconductor waveguide (12) of the laser, in such a way that the upper electric contact (13) of the laser is in contact with the central electric contact (23) of the base, and the lateral electric contacts (14, 15) of the laser (1) are in contact with the lateral electric contacts (24, 25) of the base (2).

3. Assembly according to claim 2, wherein the housing (26) has a front portion and a rear portion, the central electric contact (23) and the lateral electric contacts (24, 25) of the base (2) extend towards the rear portion which is located at the rear and at a distance from the laser (1), the laser being located in the front portion of the matrix (21), the rear portion being intended to receive electric probes for the electric power supply of the laser.

4. Assembly according to claim 3, the lateral electric contacts are moved towards the rear portion and the central electric contact (23) has, towards the rear portion, an increased width in the housing (26).

5. Assembly according to one of the previous claims 2 to 4, wherein the lateral electric contacts (24, 25) of the base (2) do not comprise any electric wire in the front portion of the matrix (21).

6. Assembly according to one of the previous claims 2 to 5, wherein the laser (1) is in the shape of an upside-down T, having a horizontal branch and a vertical branch, the vertical branch of the T corresponding to the waveguide (12) and comprising the upper electric contact (13), the horizontal branch comprising the lateral electric contacts (14, 15), and the housing (26) has the shape of a slide in the matrix (21) comprising the central electric contact at a lower end of the slide and at an upper end slender rims to the housing (26) and comprising the lateral electric contacts (24, 25) of the base.

7. Assembly according to one of the previous claims, the matrix (21) is made from a material having a thermal conductivity greater than 500W·m⁻¹·K⁻¹ for temperatures between 20 and 200K.

8. Assembly according to one of the previous claims, the matrix (21) is made from a material having a thermal expansion coefficient equal to that of the material of the semiconductor waveguide (12), + or - 20%.

9. Assembly according to one of the previous claims, the matrix (21) being made from a material having an electrical conductivity of less than 10⁶S·m⁻¹.

10. Assembly according to one of the previous claims, the upper electric contact (13) of the laser being welded to the central electric contact (23) of the base, the lateral electric contacts (14) of the laser being welded to the lateral electric contacts (24) of the base (2).
